# EUROPEAN PATENT APPLICATION

(11) **EP 4 060 360 A1**
(43) Date of publication of application: **21.09.2022**
(21) Application number: 22162708.6
(22) Date of filing: 17.03.2022
(51) Int. Cl.: G01R 33/00, G01R 33/09

(54) **MAGNETIC SENSOR**

(30) Priority: 18.03.2021 JP 2021044332
(71) Applicant: TDK Corporation, Tokyo 103-6128 (JP)
(72) Inventor: YAMAJI, Yuichiro, Tokyo, 103-6128 (JP); HARAKAWA, Osamu, Binan (PH); KAMENO, Makoto, Binan (PH)
(74) Representative: Epping - Hermann - Fischer

(57) **Abstract**

Disclosed herein is a magnetic sensor that includes a sensor chip having a first magnetic layer, a second magnetic layer, and a magnetosensitive element; a first magnetism collecting member covering the first magnetic layer; and a second magnetism collecting member having a body part covering a back surface of the sensor chip, a first protruding part connected to the body part and covering a side surface of the sensor chip, and a second protruding part connected to the first protruding part and covering the second magnetic layer. The second protruding part has a first surface facing the second magnetic layer. The first surface is higher in flatness than at least one of the other surfaces of the second magnetism collecting member.

## Description

### BACKGROUND OF THE INVENTION

### --Field of the Invention

The present invention relates to a magnetic sensor and, more particularly, to a magnetic sensor having a magnetism collecting member for collecting magnetic flux in a sensor chip.

### --Description of Related Art

Magnetic sensors are widely used in ammeters, magnetic encoders, and the like. Some magnetic sensors are provided with a magnetism collecting member for collecting magnetic flux in a sensor chip for the purpose of enhancing detection sensitivity. For example, JP 2019-158508A discloses a magnetic sensor having a first magnetism collecting member (top splitter) that covers a magnetic layer disposed at the center portion of an element formation surface and a second magnetism collecting member (back splitter) that covers the back and side surfaces of a sensor chip and covers a magnetic layer disposed at both end portions of the element formation surface.

The magnetic sensor described in JP 2019-158508A uses both the top splitter and back splitter and thus can detect a magnetic field in a direction perpendicular to the element formation surface with higher sensitivity than when using only the top splitter.

However, a method of fabricating the back splitter simply by cutting a block made of ferrite involves difficulty in detecting an extremely weak magnetic field with high sensitivity.

### SUMMARY

It is therefore an object of the present invention to enhance detection sensitivity with respect to a magnetic field in a magnetic sensor having a magnetism collecting member for collecting magnetic flux in a sensor chip.

A magnetic sensor according to the present invention includes: a sensor chip having a first magnetic layer, a second magnetic layer, and a magnetosensitive element which are formed on an element formation surface, the magnetosensitive element being positioned on a magnetic path formed by a magnetic gap between the first and second magnetic layers; a first magnetism collecting member covering the first magnetic layer; and a second magnetism collecting member having a body part covering a back surface of the sensor chip positioned on the side opposite to the element formation surface thereof, a first protruding part connected to the body part and covering a side surface of the sensor chip perpendicular to the element formation surface and back surface thereof, and a second protruding part connected to the first protruding part and covering the second magnetic layer. The second protruding part has a first surface facing the second magnetic layer, and the first surface is higher in flatness than at least one of the other surfaces of the second magnetism collecting member.

According to the present invention, the first surface of the second magnetism collecting member has a high degree of flatness, so that a gap between the first surface of the second magnetism collecting member and the sensor chip can be reduced, whereby detection sensitivity with respect to a magnetic field can be enhanced.

In the present invention, a distance between the first surface and the sensor chip may be 50 µm or less. This can further enhance detection sensitivity with respect to a magnetic field.

In the present invention, the arithmetic mean of waviness Wa of the first surface may be 50 µm or less. This can reduce a gap between the first surface and the sensor chip in a state where the first surface is pressed against the sensor chip.

The magnetic sensor according to the present invention may further include a substrate for mounting the sensor chip, the first magnetism collecting member, and the second magnetism collecting member thereon. The second magnetism collecting member may further have a second surface facing the substrate, and the second surface may be higher in flatness than at least one of the other surfaces of the second magnetism collecting member. Thus, the second surface of the second magnetism collecting member and the substrate are in close contact with substantially no gap left therebetween. This reduces friction between the second magnetism collecting member and substrate, facilitating assembly work of bringing the second magnetism collecting member into abutment against the sensor chip while sliding it on the substrate.

In the present invention, the second magnetism collecting member may be made of a ferrite material. The ferrite material remaining in a cut state is low in flatness, but the first surface can be selectively flattened through grinding or polishing.

As described above, according to the present invention, detection sensitivity with respect to a magnetic field can be enhanced in a magnetic sensor having a magnetism collecting member for collecting magnetic flux in a sensor chip.

### BRIEF DESCRIPTION OF THE DRAWINGS

The above and other objects, features and advantages of this invention will become more apparent by reference to the following detailed description of the invention taken in conjunction with the accompanying drawings, wherein:
FIG. 1 is a schematic perspective view illustrating the outer appearance of a magnetic sensor 10 according to a preferred embodiment of the present invention;
FIG. 2 is a schematic perspective view for explaining the structure of the sensor chip 20;
FIG. 3 is a schematic perspective view for explaining the positional relation between the sensor chip 20 and the magnetism collecting members 30, 40;
FIG. 4 is a circuit diagram for explaining the connection relation between the magnetosensitive elements R1 to R4;
FIG. 5 is a schematic perspective view for explaining the structure of the magnetism collecting member 30;
FIG. 6 is a schematic perspective view for explaining the structure of the magnetism collecting member 40;
FIG. 7 is a graph illustrating the relation between a arithmetic mean of waviness Wa of the inner surface 47 and a gap between the inner surface 47 of the magnetism collecting member 40 and the sensor chip 20; and
FIG. 8 is a graph illustrating the relation between sensor sensitivity and a gap formed between the inner surface 47 of the magnetism collecting member 40 and the sensor chip 20.

### DETAILED DESCRIPTION OF THE EMBODIMENTS

Preferred embodiments of the present invention will now be explained in detail with reference to the drawings.

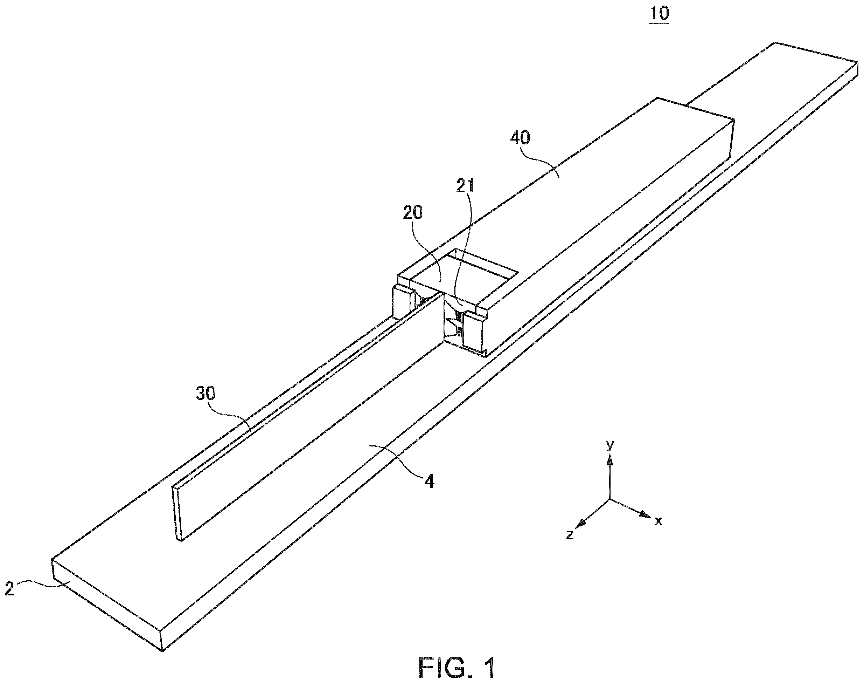

FIG. 1 is a schematic perspective view illustrating the outer appearance of a magnetic sensor 10 according to a preferred embodiment of the present invention.

As illustrated in FIG. 1, the magnetic sensor 10 according to the present embodiment includes a substrate 2 with a surface 4 constituting the xz plane, a sensor chip 20, a first magnetism collecting member 30, and a second magnetism collecting member 40 each of which is placed on the surface 4 of the substrate 2. The sensor chip 20 has an element formation surface 21. The element formation surface 21 constitutes the xy plane and faces one end of the magnetism collecting member 30 in the z-direction. The magnetism collecting member 40 is provided on the back surface side of the sensor chip 20. The magnetism collecting members 30 and 40 are each a block made of a soft magnetic material having a high permeability, such as ferrite.

As illustrated in FIG. 1, in the present embodiment, the sensor chip 20 is mounted such that the element formation surface 21 thereof is perpendicular to the surface 4 of the substrate 2. That is, the sensor chip 20 is laid at 90° with respect to the substrate 2. Thus, even when the magnetism collecting members 30 and 40 are large in length in the z-direction, they can be stably fixed on the substrate 2.

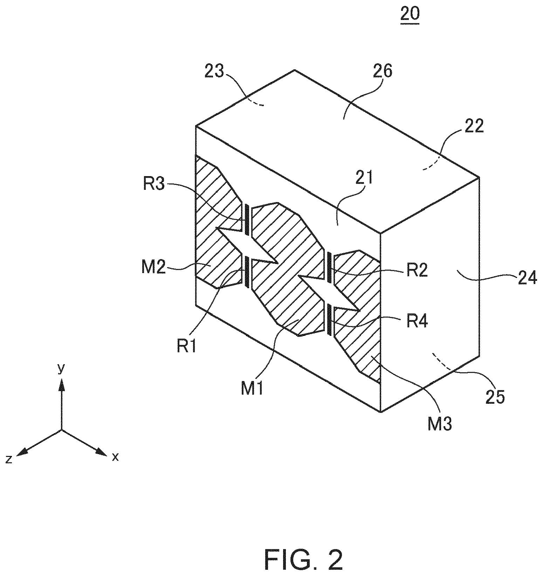

FIG. 2 is a schematic perspective view for explaining the structure of the sensor chip 20.

As illustrated in FIG. 2, the sensor chip 20 has a substantially rectangular parallelepiped shape and has four magnetosensitive elements R1 to R4 on the element formation surface 21 constituting the xy plane. The opposite side of the element formation surface 21 is a back surface 22 constituting the xy plane. Besides, the sensor chip 20 has side surfaces 23 and 24 constituting the yz plane and positioned on the mutually opposite sides and lower and upper surfaces 25 and 26 constituting the xz plane and positioned on the mutually opposite sides. The sensor chip 20 is placed on the substrate 2 such that the lower surface 25 faces the surface 4 of the substrate 2.

The magnetosensitive elements R1 to R4 are not particularly limited in type as long as characteristics thereof change according to the direction or strength of a magnetic field and may be, for example, magnetoresistive elements. In the following description, the magnetosensitive elements R1 to R4 are assumed to be magnetoresistive elements and to have the same fixed magnetization direction. The magnetosensitive elements R1 and R3 are at the same x-direction position, and the magnetosensitive elements R2 and R4 are at the same x-direction position. Further, the magnetosensitive elements R1 and R4 are at the same y-direction position, and the magnetosensitive elements R2 and R3 are at the same y-direction position.

Magnetic layers M1 to M3 are formed on the element formation surface 21 of the sensor chip 20. The magnetic layer M1 is positioned at substantially the center on the element formation surface 21 in a plan view, and the magnetic layers M2 and M3 are positioned on opposite sides of the magnetic layer M1 in the x-direction. Although not particularly limited, the magnetic layers M1 to M3 each may be a film made of a composite magnetic material obtained by dispersing magnetic filler in a resin material or may be a thin film or a foil made of a soft magnetic material, such as nickel or permalloy, or may be a thin film or a bulk sheet made of ferrite or the like. The magnetosensitive elements R1 and R3 are disposed around a magnetic gap formed by the magnetic layers M1 and M2, and the magnetosensitive elements R2 and R4 are disposed around a magnetic gap formed by the magnetic layers M1 and M3. The magnetosensitive elements R1 to R4 each need not necessarily be positioned within the magnetic gap and only need to be disposed on a magnetic path formed by the magnetic gap, i.e., at a position where a magnetic field to be detected passing through the magnetic gap can be detected.

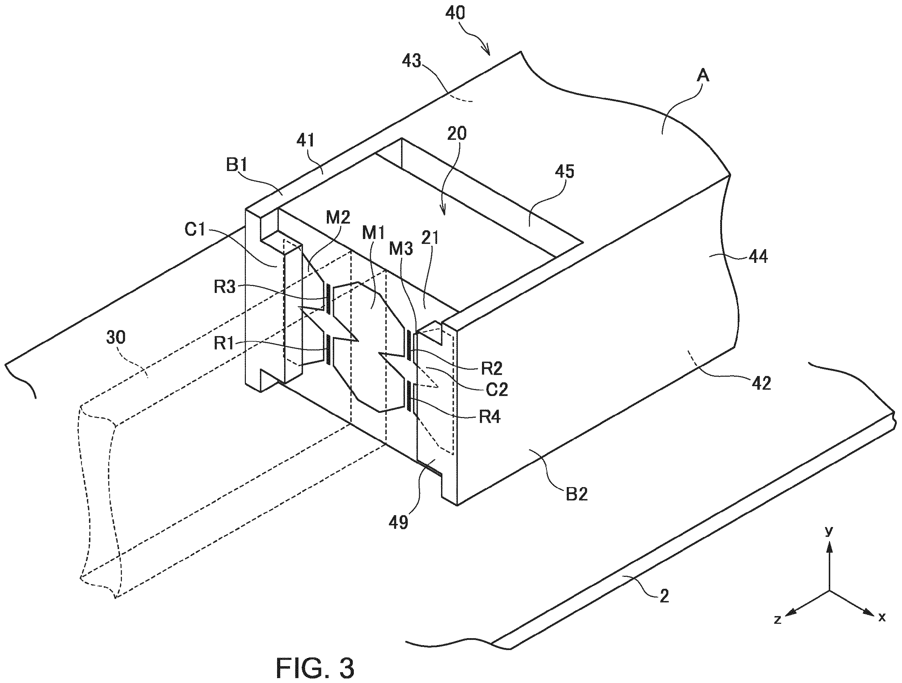

FIG. 3 is a schematic perspective view for explaining the positional relation between the sensor chip 20 and the magnetism collecting members 30, 40.

As illustrated in FIG. 3, the magnetism collecting member 30 has a substantially rectangular parallelepiped shape elongated in the z-direction and overlaps the magnetic layer M1 in a plan view (as viewed in the z-direction). The magnetism collecting member 30 functions as a top splitter that applies magnetic flux in the z-direction to the magnetic layer M1 and distributes the magnetic flux to the magnetic layers M2 and M3 positioned on the opposite sides of the magnetic layer M1 in the x-direction. The height of the magnetism collecting member 30 in the z-direction is not particularly limited; however, when the height thereof is increased, selectivity with respect to magnetic flux in the z-direction can be improved. In the present embodiment, the width of the magnetism collecting member 30 in the y-direction substantially coincides with the width of the sensor chip 20 in the y-direction, but not limited to this.

The back surface 22 and side surfaces 23, 24 of the sensor chip 20 are covered with the magnetism collecting member 40. The magnetism collecting member 40 has a body part A covering the back surface 22 of the sensor chip 20, first protruding parts B1 and B2 connected to the body part A and covering respectively the side surfaces 23 and 24 of the sensor chip 20, and second protruding parts C1 and C2 connected respectively to the first protruding parts B1 and B2 and covering the element formation surface 21 of the sensor chip 20. The protruding parts C1 and C2 cover the magnetic layers M2 and M3, respectively.

Thus, as viewed in the z-direction, the magnetosensitive elements R1 and R3 are positioned between the magnetism collecting member 30 and the protruding part C1 of the magnetism collecting member 40, and the magnetosensitive elements R2 and R4 are positioned between the magnetism collecting member 30 and the protruding part C2 of the magnetism collecting member 40. It follows that magnetic flux collected by the magnetism collecting member 30 at the magnetic layer M1 is substantially evenly distributed to the magnetic layers M2 and M3 and then absorbed into the body part A of the magnetism collecting member 40 through the protruding parts C1 and C2. At this time, a part of the magnetic flux passes through the magnetosensitive elements R1 to R4. That is, magnetic fluxes in mutually opposite directions are applied to the magnetosensitive elements R1, R3 and magnetosensitive elements R2, R4. Thus, the magnetism collecting member 40 functions as a back splitter that collects the magnetic flux split by the magnetism collecting member 30.

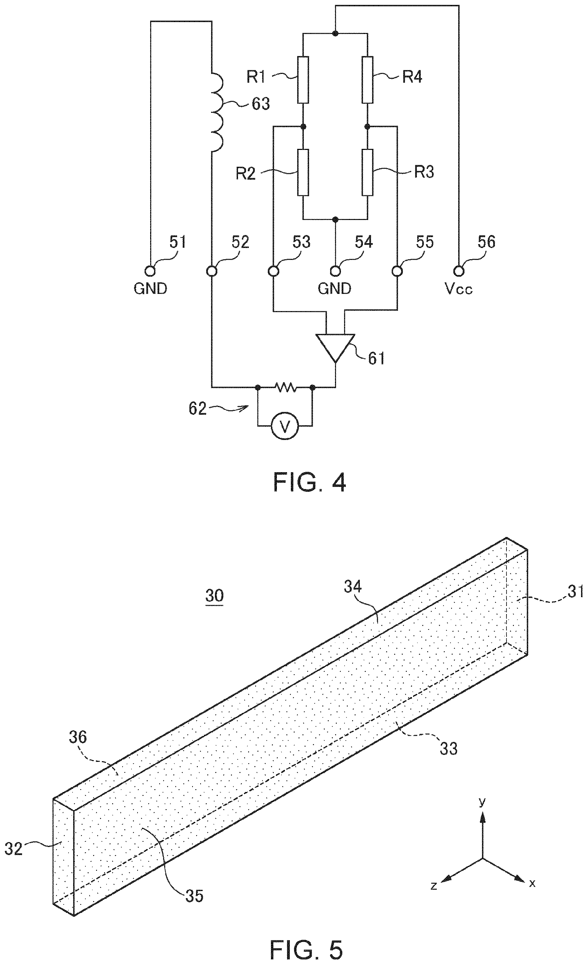

FIG. 4 is a circuit diagram for explaining the connection relation between the magnetosensitive elements R1 to R4.

As illustrated in FIG. 4, the magnetosensitive element R1 is connected between the terminal electrodes 53 and 56, the magnetosensitive element R2 is connected between the terminal electrodes 53 and 55, the magnetosensitive element R3 is connected between the terminal electrodes 54 and 55, and the magnetosensitive element R4 is connected between the terminal electrodes 55 and 56. The terminal electrode 56 is applied with a power supply potential Vcc, and the terminal electrode 54 is applied with a ground potential GND. The magnetosensitive elements R1 to R4 have the same fixed magnetization direction, and a difference occurs between the resistance variation of the magnetosensitive elements R1, R3 positioned on one side as viewed from the magnetism collecting member 30 and the resistance variation of the magnetosensitive elements R2, R4 positioned on the other side as viewed from the magnetism collecting member 30. As a result, the magnetosensitive elements R1 to R4 constitute a differential bridge circuit, and thus a change in electrical resistance of the magnetosensitive elements R1 to R4 according to a magnetic flux density appears in the terminal electrodes 53 and 55.

Differential signals output from the terminal electrodes 53 and 55 are input to a differential amplifier 61 provided on or outside the substrate 2. An output signal from the differential amplifier 61 is fed back to the terminal electrode 52. As illustrated in FIG. 4, a compensation coil 63 is connected between the terminal electrodes 51 and 52 and thus generates a magnetic field according to the output signal from the differential amplifier 61. The compensation coil 63 can be integrated in the sensor chip 20. Thus, when a change in electric resistance of the magnetosensitive elements R1 to R4 according to a magnetic flux density appears in the terminal electrodes 53 and 55, a current corresponding to the magnetic flux density flows in the compensation coil 63 to generate magnetic flux in the opposite direction, whereby the external magnetic flux is canceled. Then, by converting the current output from the differential amplifier 61 into voltage using a detection circuit 62, the direction and strength of the external magnetic flux can be detected.

FIG. 5 is a schematic perspective view for explaining the structure of the magnetism collecting member 30.

As illustrated in FIG. 5, the magnetism collecting member 30 has a substantially rectangular parallelepiped shape with six surfaces 31 to 36. The surface 31 constitutes the xy plane and faces the element formation surface 21 of the sensor chip 20 in a mounted state. The surface 33 constitutes the xz plane and faces the surface 4 of the substrate 2 in a mounted state. The surface 32 constitutes the xy plane positioned on the side opposite to the surface 31. The surface 34 constitutes the xz plane positioned on the side opposite to the surface 33. The surfaces 35 and 36 constitute the yz plane and opposite to each other.

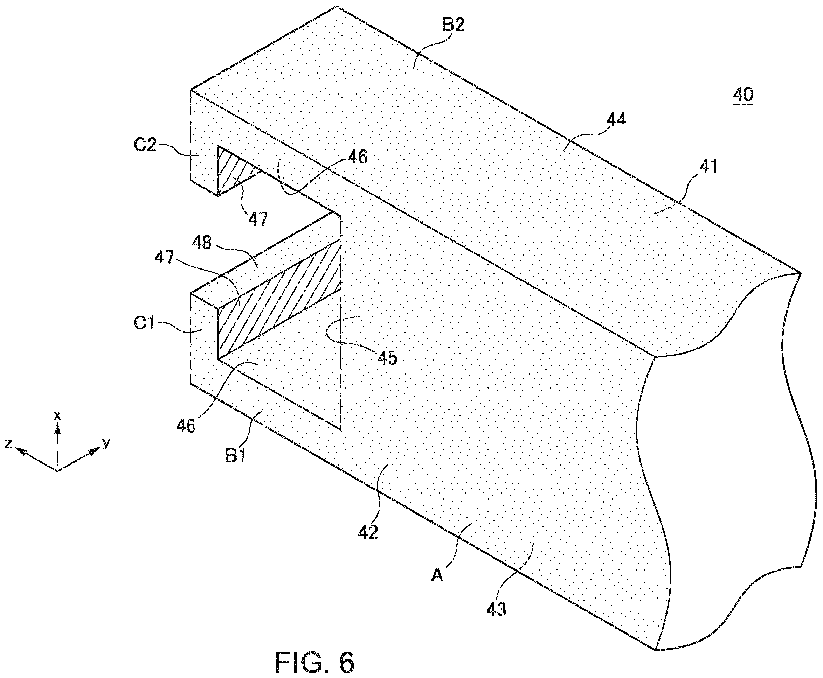

FIG. 6 is a schematic perspective view for explaining the structure of the magnetism collecting member 40.

As illustrated in FIGS. 1, 3, and 6, the magnetism collecting member 40 has the body part A with a substantially rectangular parallelepiped shape, the protruding parts B1 and B2 connected to the body part A and protruding in the z-direction, and the protruding parts C1 and C2 connected respectively to the protruding parts B1 and B2 and protruding in the x-direction. As described above, the protruding part C1 overlaps the magnetic layer M2 in the z-direction, and the protruding part C2 overlaps the magnetic layer M3 in the z-direction.

The magnetism collecting member 40 has upper and lower surfaces 41 and 42 constituting the xz plane, side surfaces 43 and 44 constituting the yz plane, an inner surface 45 constituting the xy plane, an inner surface 46 constituting the yz plane, an inner surface 47 constituting the xy plane, an end surface 48 constituting the yz plane, and an end surface 49 constituting the xy plane. In a mounted state of the magnetism collecting member 40, the lower surface 42 faces the surface 4 of the substrate 2, the inner surface 45 faces the back surface 22 of the sensor chip 20, the inner surface 46 faces the side surfaces 23 and 24 of the sensor chip 20, and the inner surface 47 faces the element formation surface 21 of the sensor chip 20 so as to overlap the magnetic layers M2 and M3. In particular, the inner surface 47 preferably contacts a protective film covering the magnetic layers M2 and M3, i.e., the surface of the sensor chip 20.

While the inner surface 45 of the magnetism collecting member 40 may contact the back surface 22 of the sensor chip 20, a gap may be provided therebetween so as to press the protruding parts C1 and C2 of the magnetism collecting member 40 against the element formation surface 21 of the sensor chip 20. Further, the inner surface 46 of the magnetism collecting member 40 may be slightly separated from the side surfaces 23 and 24 of the sensor chip 20 so as to allow adjustment of the relative position between the sensor chip 20 and the magnetism collecting member 40 in the z-direction.

In the present embodiment, at least the inner surface 47 of the magnetism collecting member 40 is flattened. This results from grinding or polishing applied to the inner surface 47 of the magnetism collecting member 40. Thus, when the inner surface 47 of the magnetism collecting member 40 is pressed against the sensor chip 20, they are in close contact with substantially no gap left therebetween, which can suppress a reduction in detection sensitivity due to the gap therebetween and reduce a variation in detection sensitivity among products. Specifically, grinding or polishing is preferably performed so as to make the arithmetic mean of waviness Wa (defined in JIS B 0601: 2013) of the inner surface 47 equal to or less than 50 µm and more preferably equal to or less than 20 µm.

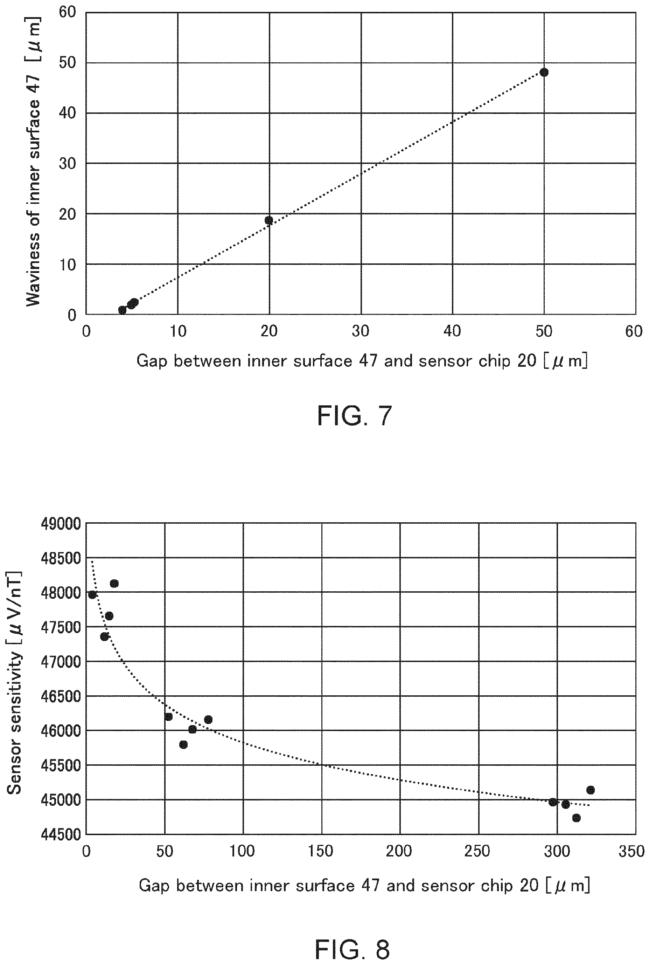

As illustrated in FIG. 7, when the arithmetic mean of waviness Wa of the inner surface 47 is equal to or less than 50 µm, a gap between the inner surface 47 of the magnetism collecting member 40 and the sensor chip 20 can be reduced to 50 µm or less in a state where the protruding parts C1 and C2 of the magnetism collecting member 40 are pressed against the surface of the sensor chip 20. Further, when the arithmetic mean of waviness Wa of the inner surface 47 is equal to or less than 20 µm, a gap between the inner surface 47 of the magnetism collecting member 40 and the sensor chip 20 can be reduced to 20 µm or less in a state where the protruding parts C1 and C2 of the magnetism collecting member 40 are pressed against the surface of the sensor chip 20.

FIG. 8 is a graph illustrating the relation between sensor sensitivity and a gap formed between the inner surface 47 of the magnetism collecting member 40 and the sensor chip 20. When ferrite is used as the material of the magnetism collecting member 40, the arithmetic mean of waviness Wa of the inner surface 47 is about 300 µm unless the flattening is performed and, in this case, sensor sensitivity is about 45,000 µV/nT. When a gap between the inner surface 47 of the magnetism collecting member 40 and the sensor chip 20 is about 50 µm, sensor sensitivity increases to about 46,000 µV/nT. Further, when a gap between the inner surface 47 of the magnetism collecting member 40 and the sensor chip 20 is about 20 µm, sensor sensitivity increases to about 48,000 µV/nT.

Not only the inner surface 47 of the magnetism collecting member 40, but also other surfaces of the magnetism collecting member 40 may be flattened. However, the upper surface 41 and side surfaces 43, 44 need not be flattered because the surface properties thereof have no influence on sensor sensitivity. Rather, they are preferably not to be flattened (preferably made to remain in a state where the magnetism collecting member 40 is cut out from a block made of a magnetic material such as ferrite) for reduction in machining cost. On the other hand, the lower surface 42 is preferably flattened like the inner surface 47. When the lower surface 42 is flattened, the lower surface 42 and the surface 4 of the substrate 2 are in close contact with substantially no gap left therebetween in a state where the magnetism collecting member 40 is mounted on the substrate 2. This reduces friction between the lower surface 42 of the magnetism collecting member 40 and the surface 4 of the substrate 2, thus facilitating assembly work of bringing the magnetism collecting member 40 into abutment against the sensor chip 20 while sliding it on the surface 4 of the substrate 2. The arithmetic mean of waviness Wa of the lower surface 42 may be the same or larger than that of the inner surface 47.

Further, not only the magnetism collecting member 40, but also the surface of the magnetism collecting member 30 is preferably flattened. In particular, when the surface 31 of the magnetism collecting member 30 is flattened, it is possible to significantly suppress a reduction in detection sensitivity due to a gap between the element formation surface 21 and the magnetism collecting member 30 and to significantly reduce a variation in detection sensitivity among products. Further, when the surface 33 of the magnetism collecting member 30 is flattened, the surface 33 and the surface 4 of the substrate 2 are in close contact with substantially no gap left therebetween, and an angle formed by the surfaces 31 and 33 becomes close to 90°, so that a variation in gap size between the element formation surface 21 of the sensor chip 20 and the magnetism collecting member 30 can be reduced. In addition, friction between the surface 33 of the magnetism collecting member 30 and the substrate 2 is reduced, thus facilitating assembly work of bringing the magnetism collecting member 30 into abutment against the sensor chip 20 while sliding it on the substrate 2.

As described above, in the magnetic sensor 10 according to the present embodiment, the magnetism collecting member 30 that functions as a top splitter and the magnetism collecting member 40 that functions as a back splitter are used to collect magnetic flux in the sensor chip 20, and the inner surfaces 47 of the protruding parts C1 and C2 of the magnetism collecting member 40 are selectively flattened, so that it is possible to enhance detection sensitivity while suppressing an increase in machining cost.

While the preferred embodiment of the present disclosure has been described, the present disclosure is not limited to the above embodiment, and various modifications may be made within the scope of the present disclosure, and all such modifications are included in the present disclosure.

## Claims

1. A magnetic sensor comprising:
a sensor chip having a first magnetic layer, a second magnetic layer, and a magnetosensitive element which are formed on an element formation surface, the magnetosensitive element being positioned on a magnetic path formed by a magnetic gap between the first and second magnetic layers;
a first magnetism collecting member covering the first magnetic layer; and
a second magnetism collecting member having a body part covering a back surface of the sensor chip positioned on a side opposite to the element formation surface thereof, a first protruding part connected to the body part and covering a side surface of the sensor chip perpendicular to the element formation surface and back surface thereof, and a second protruding part connected to the first protruding part and covering the second magnetic layer,
wherein the second protruding part has a first surface facing the second magnetic layer, and
wherein the first surface is higher in flatness than at least one of other surfaces of the second magnetism collecting member.

2. The magnetic sensor as claimed in claim 1, wherein a distance between the first surface and the sensor chip is 50 µm or less.

3. The magnetic sensor as claimed in claim 1 or 2, wherein an arithmetic mean of waviness Wa of the first surface is 50 µm or less.

4. The magnetic sensor as claimed in any one of claims 1 to 3, further comprising a substrate for mounting the sensor chip, the first magnetism collecting member, and the second magnetism collecting member thereon,
wherein the second magnetism collecting member further has a second surface facing the substrate, and
wherein the second surface is higher in flatness than at least one of other surfaces of the second magnetism collecting member.

5. The magnetic sensor as claimed in any one of claims 1 to 4, wherein the second magnetism collecting member comprises a ferrite material.
